## Europäisches Patentamt

## European Patent Office

## Office européen des brevets

(19)

(11) Veröffentlichungsnummer: **0 102 486**
**B1**

(12)

# EUROPÄISCHE PATENTSCHRIFT

(45) Veröffentlichungstag der Patentschrift:
**07.01.87**

(51) Int. Cl.⁴: **A 61 B 5/05,** G 01 N 24/06,
H 01 F 27/30

(21) Anmeldenummer: **83106884.6**

(22) Anmeldetag: **13.07.83**

(54) **Vorrichtung zur Justierung und Halterung von Magnetspulen eines Magnetsystems zur Kernspin-Tomographie.**

(30) Priorität: **26.07.82 DE 3227844**

(43) Veröffentlichungstag der Anmeldung:
**14.03.84 Patentblatt 84/11**

(45) Bekanntmachung des Hinweises auf die Patenterteilung:
**07.01.87 Patentblatt 87/2**

(84) Benannte Vertragsstaaten:
**DE FR GB NL**

(56) Entgegenhaltungen:
**EP - A - 0 011 335**
**DE - A - 2 741 544**
**DE - A - 2 921 252**
**DE - A - 2 932 001**

(73) Patentinhaber: **Siemens Aktiengesellschaft Berlin und München, Wittelsbacherplatz 2, D-8000 München 2 (DE)**

(72) Erfinder: **Forster, Helmut, Forchheimer Strasse 27, D-8524 Neunkirchen (DE)**
Erfinder: **Siebold, Horst, Dr., Starenweg 3, D-8520 Erlangen (DE)**
Erfinder: **Heinzelmann, Karl-Georg, Weingasse 61, D-8524 Neunkirchen (DE)**

# Beschreibung

Die Erfindung bezieht sich auf eine Vorrichtung zur räumlichen Justierung und Halterung einzelner auf einer gemeinsamen Achse hintereinandergereihter Magnetspulen eines Magnetsystems, die zur Erzeugung eines homogenen magnetischen Grundfeldes einer Anlage der Kernspin-Tomographie dienen und deren gegenseitigen Ausrichtungen mittels mechanischer Stelleinrichtungen, die mit ortsfesten Teilen einer Rahmenstruktur verbunden sind, justierbar sind. Eine derartige Justierungs- und Halterungsvorrichtung ist z.B. aus der US-PS 4 315 216 bekannt.

Auf dem Gebiet der medizinischen Diagnostik sind bildgebende Verfahren entwickelt worden, bei denen durch rechnerische oder messtechnische Analyse integraler Resonanzsignale von Kernen wie z.B. Protonen aus der räumlichen Spindichte- und/oder Relaxationszeitverteilung eines zu untersuchenden Körpers ein Bild ähnlich einem Röntgentomogramm konstruiert wird. Das entsprechende Verfahren wird auch als Zeugmatographie bezeichnet («Nature», Bd. 242, 1973, Seiten 190 und 191).

Da bekanntlich das Kernresonanzsignal mit wachsendem magnetischem Grundfeld zunimmt, wird für Anlagen der Kernspin-Tomographie ein möglichst starkes Grundfeld angestrebt, das in einem Messbereich eine ausreichende Homogenität aufweist. Dieses Grundfeld ist von stationären und/oder gepulsten Gradientenfeldern überlagert. Ausserdem muss ein senkrecht zu dem Grundfeld orientiertes Hochfrequenzfeld vorgesehen werden. Die Abmessungen der entsprechenden Magnetspulen sind den Dimensionen des zu untersuchenden Körpers so anzupassen, dass dieser in den von den Spulen umgebenen Messbereich ohne weiteres eingeschoben werden kann.

Aus der eingangs genannten US-PS 4 315 216 ist auch ein Magnetsystem zur Erzeugung eines Grundfeldes bekannt, das vier auf einer gemeinsamen, horizontalen Achse hintereinandergereihte, ringförmige Magnetspulen aufweist. Da bekanntlich an die Homogenität des Feldes dieser Spulen hohe Anforderungen gestellt werden und beispielsweise in dem gesamten Messvolumen die magnetische Feldstärke nicht mehr als um 0,1‰ schwanken sollte, müssen die einzelnen Spulen des Magnetsystems geometrisch feinjustiert werden. Denn selbst bei höchster Fertigungspräzision der Magnetspulen wäre dies notwendig, um beispielsweise den Einfluss von Eisenteilen in der Umgebung des Magnetsystems kompensieren zu können. Jede der vier Magnetspulen besitzt maximal drei Translations- und zwei Rotationsfreiheitsgrade. Dementsprechend ist eine Anzahl von Justiervorrichtungen vorzusehen, mit denen eine gegenseitige Ausrichtung der einzelnen Magnetspulen möglich ist. Bei dem bekannten Magnetsystem stützen sich alle vier justierbaren Magnetspulen an einer gemeinsamen Bodenplatte ab. An einer Stirnseite jeder der Magnetspulen sind vier radial nach aussen weisende, plattenförmige Elemente in Umfangsrichtung regelmässig verteilt befestigt. Die entsprechenden plattenförmigen Elemente der vier Magnetspulen sind jeweils über eine gemeinsame Gewindestange untereinander verbunden. Die Justierung der einzelnen Spulen innerhalb der so ausgebildeten Rahmenstruktur erfolgt durch eine Verstellung der Befestigungsmuttern, mit denen ihre plattenförmigen Elemente an der jeweiligen Gewindestange befestigt sind. Ausserdem können die einzelnen Magnetspulen des bekannten Magnetsystems über an der Bodenplatte angreifende Stelleinrichtungen in vertikaler Richtung ausgerichtet werden (vgl. Fig. 4a und 4b). Bei diesem bekannten Magnetsystem ist der Justierungsaufwand verhältnismässig gross, da für jede Magnetspule fünf Stelleinrichtungen vorgesehen sind. Da ferner die einzelnen Magnetspulen über die vier Gewindestangen untereinander verbunden sind, führen thermische Längenänderungen und Erschütterungen dieser Spulen zu einer Dejustierung des gesamten Systems und somit zu einer entsprechenden Verschlechterung der Homogenität des magnetischen Grundfeldes. Eine Nachjustierung ist in diesem Fall verhältnismässig schwierig.

Aufgabe der Erfindung ist es, die eingangs genannte Justierungs- und Halterungsvorrichtung so auszugestalten, dass mit ihr eine verhältnismässig einfache Justierung der einzelnen Magnetspulen möglich ist und zugleich eine hohe Homogenität des magnetischen Grundfeldes zu erreichen ist.

Diese Aufgabe wird erfindungsgemäss dadurch gelöst,

a) dass mindestens eine der Magnetspulen mit der Rahmenstruktur starr verbunden ist,

b) dass jede justierbare Magnetspule innerhalb der Rahmenstruktur an drei Punkten gehaltert ist, sich über mindestens eine Abstützungseinrichtung auf der Rahmenstruktur abstützt und an ihren Halterungspunkten jeweils mit einer Stelleinrichtung zu ihrer Justierung versehen ist,

c) dass jede Abstützungseinrichtung ein kugelkalottenförmiges Abstützungselement enthält, das mit seinem Kugelflächenteil in einer Ausnehmung der Abstützungseinrichtung mit an die Kugelfläche angepasster Gestalt drehbeweglich und mit seiner Flachseite bezüglich der Rahmenstruktur verschiebbar angeordnet ist, und

d) dass jeder der von den Abstützungseinrichtungen festgelegten Abstützungspunkte ausserhalb der Schwerpunktslinie der jeweils zugeordneten Magnetspule derart angeordnet ist, dass eine Kippkraft auf die jeweilige Magnetspule in Richtung zum Zentrum des Magnetsystems hervorgerufen ist.

Die Erfindung geht dabei von der Erkenntnis aus, dass, bezogen auf eine Spule, von drei translatorischen Bewegungen zwei Freiheitsgrade, nämlich die Höhenverstellung und die seitliche Verschiebung, bei Einengung der Herstellungstoleranzen nicht berücksichtigt zu werden brauchen, da ihre magnetische Wirkung auch durch die Rotationen erzeugt werden kann. Bei der Gesamtheit der Freiheitsgrade aller Spulen kann auf die Translation des gesamten Magnetsystems und die Berücksichtigung der beiden Winkel der Magnetachse im Raum verzichtet werden, da hierdurch die Homogenität des Magnetfeldes nicht beeinflusst wird. Somit ist bei den einzelnen Magnetspulen im wesentlichen nur eine Justierung an den drei Abstützungspunkten erforderlich. Da ferner mindestens eine der Magnetspulen mit der Rahmenstruktur starr verbunden ist, ist ihre Steifigkeit entsprechend gross.

Mit der kugelkalottenförmigen Gestaltung der Abstützungselemente kann eine Behinderung einer Kippung der justierbaren Magnetspulen und einer Verschiebung in Richtung der gemeinsamen Achse vermieden werden. Aufgrund der vorbestimmten Anordnung der kugelkalottenförmigen Abstützungselemente kommt es wegen der so erzeugten labilen Lage der jeweiligen Magnetspule zusätzlich zu einer Kippkraft, die vorteilhaft zur Erhöhung der Stützkraft auf die Stelleinrichtung, insbesondere im nicht-erregten Zustand des Magnetsystems, ausgenutzt werden kann. Die Konstruktion ist somit weitgehend unempfindlich gegenüber Erschütterungen, thermischen Längenänderungen sowie mechanischem Spiel.

Besonders vorteilhaft ist, wenn gemäss weiterer Ausgestaltung der Vorrichtung nach der Erfindung diese für ein Magnetsystem mit mindestens fünf Magnetspulen vorgesehen ist. Der Justieraufwand, insbesondere der Mindestverstellweg jeder Stelleinrichtung, ist dann verhältnismässig klein. Vorzugsweise kann das Magnetsystem sechs Magnetspulen umfassen, wobei die beiden stirnseitigen und die beiden inneren Magnetspulen justierbar sind. Mit einem solchen System lassen sich uneingeschränkt allein durch mechanische Verrückungen die Fertigungstoleranzen der einzelnen Magnetspulen auskorrigieren. Weitere vorteilhafte Ausgestaltungen der erfindungsgemässen Vorrichtung sind in den restlichen Unteransprüchen gekennzeichnet.

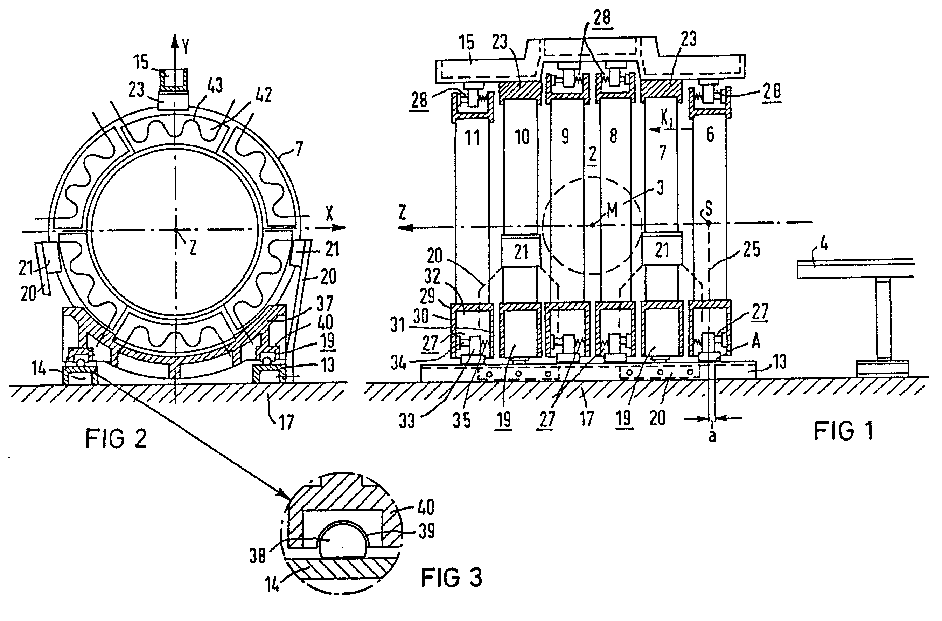

Die Erfindung wird nachfolgend anhand der Zeichnung noch weiter erläutert, in deren Figuren 1 und 2 ein Längsschnitt bzw. ein Querschnitt durch ein Magnetsystem mit einer Justierungs- und Halterungsvorrichtung nach der Erfindung schematisch veranschaulicht sind. Figur 3 zeigt einen Ausschnitt einer in Figur 2 gezeigten Abstützungseinrichtung der Justierungs- und Halterungsvorrichtung.

Bei dem in Figur 1 dargestellten Magnetsystem zur Kernspin-Tomographie bzw. Zeugmatographie wird von bekannten Magnetspulenanordnungen ausgegangen (vgl. «Computertomographie», Band 1 (1981), Seiten 2 bis 10). Eine entsprechende Magnetspulenanordnung enthält mindestens ein bezüglich der horizontalen z-Achse eines rechtwinkligen x-y-z-Koordinatensystems konzentrisch angeordnetes normal- oder supraleitendes Magnetsystem 2 zur Erzeugung eines magnetischen Grundfeldes in z-Richtung. Dieses Grundfeld ist in einem durch eine gestrichelte Linie angedeuteten Feldbereich 3, in dessen Zentrum M sich der Koordinatenursprung des Koordinatensystems befinden soll, ausreichend homogen. Ferner sind in der Figur nicht dargestellte Gradientenspulen zur Erzeugung hinreichend konstanter magnetischer Feldgradienten in dem Feldbereich 3 vorgesehen. Die Anregung der Kernspins erfolgt mittels eines senkrecht zur z-Achse gerichteten Hochfrequenzfeldes von in der Figur nicht ausgeführten Spulen, die auch als Empfängerspulen zur Aufnahme der Kernspinresonanzsignale dienen können. Die gesamte Magnetspulenanordnung und somit auch das Magnetsystem 2 erlaubt einen axialen Zugang zu dem homogenen Feldbereich 3, d.h. ein zu untersuchender, beispielsweise menschlicher Körper wird längs der z-Achse in das Magnetfeld, z.B. auf einer Liege 4, eingebracht.

Das Magnetsystem 2 umfasst vorteilhaft sechs längs der z-Achse hintereinandergereihte, ringförmige Magnetspulen 6 bis 11. Zwei dieser Magnetspulen, vorzugsweise die den stirnseitigen Magnetspulen 6 bzw. 11 benachbarten Spulen 7 bzw. 10 sind dabei starr mit einer Rahmenstruktur verbunden, die zwei Tragschienen und eine Halteschiene umfasst. Die Anordnung dieser Schienen 13 bis 15 geht aus Figur 2 näher hervor. In Figur 1 sind nur eine dieser Tragschienen, beispielsweise die Tragschiene 13, und die Halteschiene 15 ersichtlich. Auf den Tragschienen, die auf einem Unterbau 17 aufliegen, stützen sich die Magnetspulen 7 und 10 über in Figur 1 nicht näher ausgeführte Abstützungseinrichtungen 19 ab und sind an diesen Schienen unverrückbar befestigt. Hierzu dienen Bleche 20, sogenannte Knotenbleche, die über Klauen 21 seitlich an den Magnetspulen 7 bis 10 angreifen und mit den Tragschienen 13 und 14 verschraubt sind. Die somit ortsfesten Magnetspulen 7 und 10 sind an ihrem oberen Teil jeweils über ein klauenförmiges Befestigungselement 23 starr mit der Halteschiene 15 verbunden. Die Tragschienen 13 und 14 sowie die Halteschiene 15 bilden somit zusammen mit den Magnetspulen 7 und 10 die starre Rahmenstruktur, in welcher die übrigen Magnetspulen 6, 8, 9 und 11 mit Vorrichtungen nach der Erfindung justierbar angeordnet sind.

Diese Vorrichtungen nach der Erfindung enthalten neben mechanischen Stelleinrichtungen zur gegenseitigen Ausrichtung der Magnetspulen noch Abstützungseinrichtungen, die in Figur 2 näher veranschaulicht sind. Die Abstützungspunkte dieser Abstützungseinrichtungen sollen dabei erfindungsgemäss ausserhalb der Schwerpunktslinie der jeweiligen Magnetspule derart angeordnet sein, dass eine Kippkraft auf die jeweilige Magnetspule in Richtung zum Zentrum M des Magnetsystems 2 hin hervorgerufen wird. In Figur 1 ist dies für die Magnetspule 6 angedeutet. Dementsprechend ist ihr mit A bezeichneter Abstützungspunkt um einen vorbestimmten Abstand a in z-Richtung von der durch den Schwerpunkt S der Spule verlaufenden, gestrichelt dargestellten Schwerpunktslinie 25 weiter von der Magnetsystemmitte M entfernt. Die deshalb an der Magnetspule 6 angreifende Kippkraft ist durch eine mit K bezeichnete, gepfeilte Linie angedeutet.

Die Abstützungspunkte der justierbaren Magnetspulen 6, 8, 9 und 11 auf den Tragschienen 13 und 14 sowie die Kippungen dieser Magnetspulen aus der x-y-Ebene aufgrund dieser Kippkraft K lassen sich mit Stelleinrichtungen justieren. Die den Abstützungspunkten zuzuordnenden Stelleinrichtungen sind in Figur 1 mit 27 bezeichnet, während zur Abstützung an der Halteschiene 15 entsprechende Stelleinrichtungen 28 mit im wesentlichen gleichem Aufbau dienen. So sind z.B. die Stelleinrichtungen 27 mit einem rinnenförmigen, nach unten offenen Hohlprofilkörper 29 verbunden, der am unteren Aussenrand der jeweiligen justierbaren Magnetspule, beispielsweise der Spule 11, in der Nähe eines Abstützungspunktes befestigt ist. In den zwischen den beiden freien Schenkeln 30 und 31 vorhandenen Zwischenraum 32 dieses Hohlprofilkörpers 29 ragt vertikal ein an der Tragschiene 13 befestigtes Abstützungsteil 33. Die relative Lage der Schenkel 30 und 31 des Hohlprofilkörpers 29 und damit der Magnetspule 11 kann nun über eine sich im wesentlichen in z-Richtung erstreckende Justierspindel 34 eingestellt werden, die mit dem äusseren, vom Zentrum M des Magnetsystems weiter entfernt liegenden Schenkel 30 verbunden ist und sich an dem mit der Tragschiene 13 starr verbundenen Teil 33 abstützt. Zwischen diesem Abstützungsteil 33 und dem anderen freien Schenkel 31 ist ein Federelement 35 eingespannt. Dieses Federelement 35 drückt die Magnetspule auch im nicht-erregten Zustand des Magnetsystems gegen die Stellspindel 34. Somit besteht immer eine kraftschlüssige Verbindung von der Spule über die Stellspindel auf die Tragschiene.

Über die oberen Stelleinrichtungen 28 sind die justierbaren Magnetspulen 6, 8, 9 und 11 mit der Halteschiene 15 in entsprechender Weise verbunden. Dabei wird die Kippkraft K zur Erhöhung der auf die Stellspindeln einwirkenden Abstützungskräfte ausgenutzt.

Aus den Figuren 2 und 3 geht die Abstützung der Magnetspulen des Magnetsystems an drei Punkten innerhalb einer Rahmenstruktur näher hervor. In der Figur ist zwar die Frontansicht auf eine der starr mit der Rahmenstruktur verbundenen Magnetspulen, beispielsweise auf die Magnetspule 7 gemäss Figur 1 dargestellt; die Abstützung ist jedoch für die justierbaren Spulen entsprechend. Mit Figur 1 übereinstimmende Teile sind dabei mit den gleichen Bezugszeichen versehen.

Die Magnetspule 7 ist auf ihrer Unterseite in einem Trägerkörper befestigt, beispielsweise in ein Prisma oder eine Jochschale 37 gelegt und formschlüssig mit Giessharzmasse ausgegossen. Diese die Magnetspule tragende Jochschale weist zwei Abstützungseinrichtungen 19 auf, über die sich die Magnetspule an den beiden auf dem Unterbau 17 liegenden, in z-Richtung verlaufenden Tragschienen 13 und 14 abstützt. Figur 3 zeigt dabei vergrössert den wesentlichen Teil der der Tragschiene 14 zugeordneten Abstützungseinrichtung. Diese Abstützungseinrichtung enthält ein kugelkalottenförmiges Abstützungselement 38, das mit seiner Flachseite auf der Tragschiene 14 aufliegt. Dieses Abstützungselement befindet sich mit seinem kugelförmigen Teil in einer Ausnehmung 39 einer Stütze 40, die starr mit der die Magnetspule 7 aufnehmenden Jochschale 37 verbunden ist. Die Ausnehmung 39 hat dabei eine an die Kugelfläche des kugelkalottenförmigen Abstützungselementes angepasste, beispielsweise schalenförmige Gestalt.

Aus Figur 2 sind ferner die Knotenbleche 20 und die Befestigungsklauen 21 ersichtlich, über welche die Magnetspule 7 starr mit den Tragschienen 13 und 14 verbunden ist. Über das obere klauenförmige Befestigungselement 23 ist die Magnetspule 7 ferner an der Halteschiene 15 befestigt. Bei den justierbaren Magnetspulen entfallen die Knotenbleche und die Befestigungsklauen, und die Befestigungselemente 23 sind durch Stelleinrichtungen 28 ersetzt, mit denen die Magnetspulen geringfügig zu kippen sind.

In Figur 2 sind ferner Kühlsegmente 42 mit Kühlschlangen 43 angedeutet, die zur Abführung der in der normalleitenden Magnetwicklung erzeugten Wärme an der Stirnseite der Magnetspule dienen.

Neben der in den Figuren dargestellten Abstützung und Befestigung der Magnetspulen 7 und 10 an den Tragschienen 13 und 14 können auch andere, bekannte Verbindungstechniken gewählt werden, um eine tragfähige, starre Verbindung zwischen den Magnetspulen und den Tragschienen zu gewährleisten.

Alle Teile der Vorrichtung nach der Erfindung sowie die Tragschienen und die Halteschiene werden zweckmässig aus nicht-magnetischem Material wie z.B. Aluminium gefertigt, um eine Beeinträchtigung der Homogenität des Magnetfeldes auszuschliessen.

Die drei Stelleinrichtungen der Vorrichtung nach der Erfindung für die justierbaren Magnetspulen des dargestellten Magnetsystems sind ausreichend, um eine verhältnismässig hohe Feldhomogenität von ± 20 ppm bei gezielt ausführbaren Korrekturschritten an den Stelleinrichtungen von kleiner ± 100 μm zu erreichen. Selbstverständlich können auch entsprechende Vorrichtungen nach der Erfindung für Magnetsysteme vorgesehen werden, die aus vier oder fünf einzelnen Magnetspulen zusammengesetzt sind. Bei diesen Magnetsystemen ist jedoch der Justierungsaufwand entsprechend höher. So sind insbesondere die vorzusehenden Verstellwege an den Stelleinrichtungen grösser; und auch die Anforderungen an die Fertigungstoleranzen der einzelnen Magnetspulen sind dann höher, um die genannte Feldhomogenität zu erreichen.

Aufgrund der erfindungsgemässen Abstützung der Magnetspulen über kugelkalottenförmige Abstützungselemente können die Gleit- und Kippbewegungen der einzelnen Magnete zur Justierung ohne weiteres ruckfrei durchgeführt werden, da sich der statische Reibungskoeffizient μ zwischen den bewegten Teilen ausreichend klein halten lässt. So sind Werte zwischen 0,05 und 0,1 für diesen Koeffizienten ohne weiteres zu erreichen.

Die erfindungsgemässen Vorrichtungen zur Justierung und Halterung der Magnetspulen eines Magnetsystems in einer Kernspin-Resonanz-Anlage ermöglichen bei verhältnismässig geringen Herstellungskosten eine einfache Justierung der einzelnen Magnetspulen. Ausserdem kann ein Auswechseln einzelner Spulen ohne grossen Aufwand durchgeführt werden.

**Patentansprüche**

1. Vorrichtung zur räumlichen Justierung und Halterung einzelner auf einer gemeinsamen Achse hintereinandergereihter Magnetspulen eines Magnetsystems, die zur Erzeugung eines homogenen magnetischen Grundfeldes einer Anlage der Kernspin-Tomographie dienen und deren gegenseitigen Ausrichtungen mittels mechanischer Stelleinrichtungen, die mit ortsfesten Teilen einer Rahmenstruktur verbunden sind, justierbar sind, dadurch gekennzeichnet,

a) dass mindestens eine der Magnetspulen (7, 10) mit der Rahmenstruktur (13 bis 15) starr verbunden ist,

b) dass jede justierbare Magnetspule (6, 8, 9, 11) innerhalb der Rahmenstruktur (13 bis 15) an drei Punkten gehaltert ist, sich über mindestens eine Abstützungseinrichtung (19) auf der Rahmenstruktur abstützt und an ihren Halterungspunkten jeweils mit einer Stelleinrichtung (27, 28) zu ihrer Justierung versehen ist,

c) dass jede Abstützungseinrichtung (19) ein kugelkalottenförmiges Abstützungselement (38) enthält, das mit seinem Kugelflächenteil in einer Ausnehmung (39) der Abstützungseinrichtung (19) mit an die Kugelfläche angepasster Gestalt drehbeweglich und mit seiner Flachseite bezüglich der Rahmenstruktur (13, 14) verschiebbar angeordnet ist, und

d) dass jeder der von den Abstützungseinrichtungen (19) festgelegten Abstützungspunkte (A) ausserhalb der Schwerpunktslinie (25) der jeweils zugeordneten Magnetspule (6, 8, 9, 11) derart angeordnet ist, dass eine Kippkraft (K) auf die jeweilige Magnetspule in Richtung zum Zentrum (M) des Magnetsystems hervorgerufen ist.

2. Justierungs- und Halterungsvorrichtung nach Anspruch 1, dadurch gekennzeichnet, dass die Rahmenstruktur zwei untere Tragschienen (13, 14) zur Aufnahme des Gewichts der Magnetspulen (6 bis 11) und eine obere Halteschiene (15) zur Halterung der Magnetspulen (6 bis 11) umfasst.

3. Justierungs- und Halterungsvorrichtung nach Anspruch 1 oder 2, dadurch gekennzeichnet, dass die Abstützungseinrichtungen (19) und die Rahmenstruktur (13 bis 15) sowie die Stelleinrichtungen (27, 28) aus nicht-magnetischem Material bestehen.

4. Justierungs- und Halterungsvorrichtung nach Anspruch 3, dadurch gekennzeichnet, dass die Abstützungseinrichtungen (19) und/oder die Rahmenstruktur (13 bis 15) und/oder die Stelleinrichtungen (27, 28) zumindest teilweise aus Aluminium gefertigt sind.

5. Justierungs- und Halterungsvorrichtung nach einem der Ansprüche 1 bis 4, dadurch gekennzeichnet, dass jede Stelleinrichtung (27, 28) eine sich zumindest annähernd entgegen der Kippkraft (K) an einem mit der Rahmenstruktur (13 bis 15) starr verbundenen Abstützungsteil (33) abstützende Justierspindel (34) und ein in Richtung der Kippkraft (K) wirkendes Federelement (35) enthält.

6. Justierungs- und Halterungsvorrichtung nach einem der Ansprüche 1 bis 5, gekennzeichnet durch eine Anordnung in einem Magnetsystem mit mindestens vier, vorzugsweise mit mindestens fünf Magnetspulen.

7. Justierungs- und Halterungsvorrichtung nach Anspruch 6, gekennzeichnet durch eine Anordnung in einem Magnetsystem (2) mit sechs Magnetspulen (6 bis 11), wobei die beiden den stirnseitigen Magnetspulen (6, 11) benachbarten Magnetspulen (7, 10) mit der Rahmenstruktur (13 bis 15) starr verbunden sind.

**Revendications**

1. Dispositif utilisé pour ajuster et supporter, dans l'espace, des bobines magnétiques individuelles d'un système magnétique, qui sont montées en série sur un axe commun et qui servent à produire un champ de base magnétique homogène d'une installation de tomographie à spin nucléaire et dont les orientations mutuelles peuvent être ajustées au moyen de dispositifs mécaniques de réglage, qui sont reliés à des parties fixes d'une structure en forme de cadre, caractérisé par le fait

a) qu'au moins l'une des bobines magnétiques (7, 10) est reliée rigidement à la structure en forme de cadre (13 à 15),

b) que chaque bobine magnétique ajustable (6, 8, 9, 11) est supportée en trois points à l'intérieur de la structure en forme de cadre (13 à 15), prend appui sur la structure en forme de cadre par l'intermédiaire d'au moins un dispositif de soutien (19) et est munie d'un dispositif respectif de réglage (27, 28) pour son ajustement au niveau de ses points de support,

c) que chaque dispositif de soutien (19) contient un élément de soutien (38) en forme de calotte sphérique qui est monté par son élément de surface sphérique de façon à pouvoir tourner dans un évidement (39) du dispositif de soutien (19) possédant une forme adaptée à la surface sphérique, et de manière à pouvoir se déplacer, avec sa face plane, par rapport à la structure en forme de cadre (13, 14), et

d) que chacun des points de soutien (A) fixés par les dispositifs de soutien (19) est disposé en dehors de l'axe (25) passant par le centre de gravité de la bobine magnétique (6, 8, 9, 11) respectivement associée, de telle sorte qu'une force de basculement (K) s'exerçant en direction du centre (M) du système magnétique est appliquée à la bobine magnétique respective.

2. Dispositif d'ajustement et de support suivant la revendication 1, caractérisé par le fait que la structure en forme de cadre comporte deux rails inférieurs de support (13, 14) servant à supporter le poids des bobines magnétiques (6 à 11) et un rail supérieur de support (15) servant à supporter les bobines magnétiques (6 à 11).

3. Dispositif d'ajustement et de support suivant la revendication 1 ou 2, caractérisé par le fait que les dispositifs de soutien (19) et la structure en forme de cadre (13 à 15) ainsi que les dispositifs de réglage (27, 28) sont constitués en un matériau amagnétique.

4. Dispositif d'ajustement et de support suivant la revendication 3, caractérisé par le fait que les dispositifs de soutien (19) et/ou la structure en forme de cadre (13 à 15) et/ou les dispositifs de réglage (27, 28) sont réalisés au moins en partie en aluminium.

5. Dispositif d'ajustement et de support suivant l'une des revendications 1 à 4, caractérisé par le fait que chaque dispositif de réglage (27, 28) contient une broche d'ajustement (34), qui prend appui au moins approximativement à l'encontre de la force de basculement (K) sur un élément de soutien (33) relié rigidement à la structure en forme de cadre (13 à 15), et un élément de ressort (35) agissant dans la direction de la force de basculement (K).

6. Dispositif d'ajustement et de support suivant l'une des revendications 1 à 5, caractérisé par un agencement dans un système magnétique comportant au moins quatre et de préférence au moins cinq bobines magnétiques.

7. Dispositif d'ajustement et de support suivant la revendication 6, caractérisé par un agencement dans un système amagnétique (2) comportant six bobines magnétiques (6 à 11), les deux bobines magnétiques (7, 10) voisines des bobines magnétiques frontales (6, 11) étant reliées rigidement à la structure en forme de cadre (13 à 15).

**Claims:**

1. A device for the spatial adjustment and holding of individual magnetic coils of a magnetic system which are consecutively arranged on a common axis and which serve to produce a homogeneous fundamental magnetic field of a system for nuclear spin tomography and whose mutual alignments can be adjusted by means of mechanical setting devices which are connected to stationary components of a frame structure, characterised in

a) that at least one of the magnetic coils (7, 10) is rigidly connected to the frame structure (13 to 15),

b) that within the frame structure (13 to 15) each adjustable magnetic coil (6, 8, 9, 11) is holded on three points, supported on the frame structure by means of at least one supporting device (19) and at their holding points respectively provided with a setting device (27, 28) for their adjustment,

c) that each supporting device (19) comprises a supporting element (38) which is shaped like a spherical segment and which by means of its spherical surface component is arranged so as to be rotationally movable in a recess (39) of the supporting device (19) with a shape which is matched to the spherical surface, and which by means of its flat side is displaceably arranged in relation to the frame structure (13, 14) and

d) that each of the supporting points (A), which is determined by the supporting devices (19), is arranged outside the line (25) of the centre of gravity of the respectively assigned magnetic coil (6, 8, 9, 11) in such a manner that a tilting force (K) is exerted on the respective magnetic coil in the direction of the centre (M) of the magnetic system.

2. An adjusting and holding device as claimed in claim 1, characterised in that the frame structure comprises two lower supporting rails (13, 14) for accommodating the weight of the magnetic coils (6 to 11) and an upper holding rail (15) for holding the magnetic coils (6 to 11).

3. An adjusting and holding device as claimed in claim 1 or 2, characterised in that both the supporting devices (19) and the frame structure (13 to 15) and the setting devices (27, 28) comprise a non-magnetic material.

4. An adjusting and holding device as claimed in claim 3, characterised in that the supporting devices (19) and/or the frame structure (13 to 15) and/or the setting devices (27, 28) at least partially comprise aluminium.

5. An adjusting and holding device as claimed in one of claims 1 to 4, characterised in that each setting device (27, 28) comprises an adjusting spindle (34) supported, at least approximately in opposition to the tilting force (K), on a supporting component (33) rigidly connected to the frame structure (13 to 15) and comprises a spring element (35) which acts in the direction of the tilting force (K).

6. An adjusting and holding device as claimed in one of claims 1 to 5, characterised by an arrangement in a magnetic system having at least four, preferably at least five, magnetic coils.

7. An adjusting and holding device as claimed in claim 6, characterised by an arrangement in a magnetic system (2) having six magnetic coils (6 to 11), the two magnetic coils (7, 10) adjacent the magnetic coils (6, 11) at the end faces being rigidly connected to the frame structure (13 to 15).

1/1

FIG 1

FIG 2

FIG 3